# EUROPEAN PATENT APPLICATION

(11) **EP 1 416 380 A2**
(43) Date of publication of application: **06.05.2004**
(21) Application number: 03256796.8
(22) Date of filing: 28.10.2003
(51) Int. Cl.: G06F 11/10

(54) **Method and apparatus for managing the integrity of data in a non-volatile memory system**

(30) Priority: 28.10.2002 US 421746 P
(71) Applicant: SanDisk Corporation, Sunnyvale, CA 94089 (US)
(72) Inventor: Chang, Robert C, Danville, CA 94506 (US); Qawami, Bahman, San Jose, CA 95138 (US); Sabet-Sharghi, Farshid, San Jose, CA 95138 (US)
(74) Representative: Moir, Michael Christopher

(57) **Abstract**

Methods and apparatus for encoding data associated with a page by dividing the page into segments and separately encoding the segments using extended error correction code (ECC) calculations are disclosed. According to one aspect of the present invention, a method for encoding data associated with a page which has a data area and an overhead area within a non-volatile memory of a memory system includes dividing at least a part of the page into at least two segments of the data, the at least two segments of the data including a first segment and a second segment, and performing ECC calculations on the first segment to encode the first segment. The method also includes performing the ECC calculations on the second segment to encode the second segment substantially separately from the first segment.

## Description

### BACKGROUND OF THE INVENTION

### 1. Field of Invention

The present invention relates generally to mass digital data storage systems. More particularly, the present invention relates to systems and methods for improving data storage error recovery capabilities without incurring a significant amount of overhead.

### 2. Description of the Related Art

The use of non-volatile memory systems such as flash memory storage systems is increasing due to the compact physical size of such memory systems, and the ability for non-volatile memory to be repetitively reprogrammed. The compact physical size of flash memory storage systems facilitates the use of such storage systems in devices which are becoming increasingly prevalent. Devices which use flash memory storage systems include, but are not limited to, digital cameras, digital camcorders, digital music players, handheld personal computers, and global positioning devices. The ability to repetitively reprogram non-volatile memory included in flash memory storage systems enables flash memory storage systems to be used and reused.

In general, flash memory storage systems may include flash memory cards and flash memory chip sets. Flash memory chip sets generally include flash memory components and a controller components. Typically, a flash memory chip set may be arranged to be assembled into an embedded system. The manufacturers of such assemblies or host systems typically acquire flash memory in component-form, as well as other components, then assemble the flash memory and the other components into a host system.

Often, in order to assure the accuracy of data stored in physical blocks of a flash memory, an error correction code (ECC) algorithm, or an error checking and correction code algorithm, may be used to encode data for storage, and to decode the stored data. Typically, ECC algorithms use dedicated circuitry or software to encode and to decode the data. Many ECC algorithms or methods may add a parity bit or parity bits which may be used to both detect and to correct errors associated with stored data.

Some ECC algorithms that are used to encode and to decode data for storage are known as 1-bit ECC algorithms and 2-bit ECC algorithms. 1-bit ECC algorithms enable a set of symbols to be represented such that if one bit of the representation is incorrect, e.g., is flipped, the symbols may still be correctly identified and corrected. 2-bit ECC algorithms enable a set of symbols to be represented such that if two bits of the representation are flipped or otherwise incorrect, the symbols may still be correctly identified and corrected

The implementation of a 2-bit ECC algorithm, while providing increased error correction capabilities as compared to a 1-bit ECC algorithm, generally involves more calculations and, hence, more computational overhead than the implementation of a 1-bit ECC algorithm. When more computational overhead is required, more power, e.g., battery power, may be consumed by a non-volatile memory. In addition, the implementation of a 2-bit ECC algorithm typically requires the storage of more parity bits than required for a 1-bit ECC algorithm, as will be appreciated by those skilled in the art, which may not be practical.

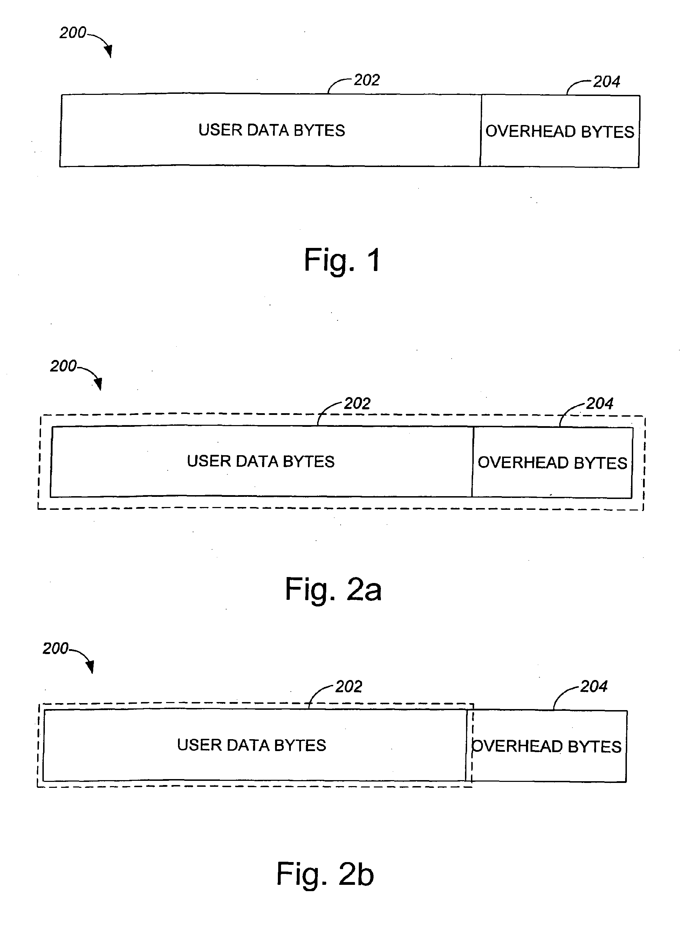

ECC algorithms are generally used to encode contents of a physical page. Fig. 1 is a diagrammatic representation of a physical page. A physical page 200 typically includes a data section 202 and an overhead section 204. Data section 202 is arranged to contain bytes of user data, *e.g.*, approximately 512 bytes of user data, while overhead section 204 is arranged to contain a number of overhead bytes, *e.g.*, approximately sixteen bytes. Typically, either all contents of physical page 200 are encoded together using an ECC algorithms, as shown in Fig. 2a, or only the contents of data section 202 are encoded together while the contents of overhead section 204 are not encoded, as shown in Fig. 2b.

When all contents of physical page 200 are encoded together, as shown in Fig. 2a, using a 1-bit ECC algorithm, then substantially only two incorrect bits may be detected within physical page 200, and only one of the detected incorrect bits may be corrected. By encoding all contents of physical page 200 together using a 2-bit ECC algorithm, although four incorrect bits may then be detected and two of the detected incorrect bits may be corrected, additional overhead is generally incurred with the use of a 2-bit ECC algorithm. In some cases, incurring additional overhead and potentially causing a performance penalty may not be considered to be worth the benefits gained by allowing two incorrect bits to be corrected.

Some systems encode substantially only contents of a data section, and not contents of an overhead section, as shown in Fig. 2b. When only the contents of a data section are encoded, then there are fewer bits which may need to be potentially corrected through the use of an ECC algorithm. However, an entire data section such as data section 202 of Fig. 2b substantially only a single incorrect bit may be corrected using a 1-bit ECC algorithm, which may not be adequate in some cases, while substantially no bits may be corrected within overhead section 204.

Therefore, what is needed is a method and an apparatus which increases the number of bits which may be corrected using an ECC algorithm without incurring significant overhead or performance penalties. That is, what is desired is a system and an apparatus which allows the number of incorrect bits which may be corrected within a page encoded using an ECC algorithm to be increased substantially without significantly increasing overhead requirements and causing performance to suffer.

It is an object of at least a preferred embodiment of the present invention to overcome or ameliorate at least one of the disadvantages of the prior art.

### SUMMARY OF THE INVENTION

According to the invention there is provided a method and a system as defined in the independent claims. Preferable features of the invention are defined in the corresponding dependent claims.

Preferred embodiments of the present invention relate to a system and a method for encoding data associated with a page by dividing the page into segments and separately encoding the segments using extended error correction code (ECC) calculations. According to one embodiment of the present invention, a method for encoding data associated with a page which has a data area and an overhead area within a non-volatile memory of a memory system includes dividing at least a part of the page into at least two segments of the data, the at least two segments of the data including a first segment and a second segment, and performing ECC calculations on the first segment to encode the first segment. The method also includes performing the ECC calculations on the second segment to encode the second segment substantially separately from the first segment.

In another embodiment, the first segment includes the data area and the second segment includes the overhead area. In another embodiment, the first segment includes a first section of the data area and the second segment includes a second section of the data area.

By allowing ECC calculations to encode data included in segments of a page substantially separately, the number of bad or incorrect bits which may be corrected within the overall page may be increased without incurring a significant performance penalty or incurring a significant amount of additional overhead. When a page is divided into at least two segments of data, the two segments may be encoded separately using an ECC algorithm. In the event that the same ECC algorithm is used to encode each segment, e.g., an ECC algorithm that detects up to two incorrect bits and corrects one incorrect bit, up to two incorrect bits in each segment may be detected, while one incorrect bit in each segment may be corrected. Hence, additional incorrect bits may be detected and corrected substantially without requiring extra overhead. The ability to correct additional incorrect bits within a page generally increases the reliability of the data stored within the page.

Another aspect of the invention includes a memory system comprising:
a non-volatile memory, the non-volatile memory including a page, the page having a data area and an overhead area, the data area and the overhead area being arranged to contain bits of data;
code devices for dividing at least a part of the page into at least two segments, the at least two segments including a first segment and a second segment;
code devices for performing error correction code (ECC) calculations on the first segment to encode the first segment and on the second segment to encode the second segment, wherein the second segment is encoded substantially separately from the first segment; and
a memory area for storing the code devices.

Preferably in this embodiment, the memory system further includes a controller, the controller being arranged to process the code devices.

These and other advantages of the present invention will become apparent upon reading the following detailed descriptions and studying the various figures of the drawings.

### BRIEF DESCRIPTION OF THE DRAWINGS

Preferred embodiments of the invention will now be described with reference to the following description taken in conjunction with the accompanying drawings in which:
Fig. 1 is a diagrammatic representation of a physical page of a non-volatile memory.
Fig. 2a is a diagrammatic representation of a physical page which is encoded as a whole using an ECC algorithm.
Fig. 2b is a diagrammatic representation of a physical page in which a data section of the physical page encoded as a whole using an ECC algorithm while an overhead section remains unencoded.
Fig. 3a is a diagrammatic representation of a general host system which includes a non-volatile memory.
Fig. 3b is a diagrammatic representation a memory device, e.g., memory device 120 of Fig. 3a.
Fig. 3c is a diagrammatic representation of a host system which includes an embedded non-volatile memory.
Fig. 4a is a diagrammatic representation of a physical page which is encoded using an ECC algorithm which is applied substantially separately to a data section of the page and an overhead section of the page in accordance with an embodiment of the present invention.
Fig. 4b is a diagrammatic representation of a physical page which is encoded using an ECC algorithm which is applied substantially separately to two segments of a data section of the page as well as an overhead section of the page in accordance with an embodiment of the present invention.
Fig. 4c is a diagrammatic representation of a physical page which is partially encoded using an ECC algorithm which is applied substantially separately to segments of a data section of the page in accordance with an embodiment of the present invention.
Fig. 5 is a diagrammatic representation of a page with incorrect bits which are corrected using a 1-bit ECC algorithm applied substantially separately to segments of the page in accordance with an embodiment of the present invention.
Fig. 6 is a process flow diagram which illustrates one method of encoding data associated with a page by dividing or otherwise breaking the page into segments and implementing an extended ECC algorithm in accordance with an embodiment of the present invention.
Fig. 7 is a diagrammatic block diagram representation of a system architecture in accordance with an embodiment of the present invention.

### DETAILED DESCRIPTION OF THE EMBODIMENTS

An error correction code (ECC) algorithm such as either a 1-bit ECC algorithm or a 2-bit ECC algorithm is often used to encode data to be stored into a physical page of a non-volatile memory, and to decode stored data. The use of ECC algorithms generally enables the accuracy of data stored within a physical page to be improved. The use of a more calculation-intensive 2-bit ECC algorithm may be preferred to a less calculation-intensive 1-bit ECC algorithm due to the ability of a 2-bit ECC algorithm to correct more erroneous bits that may be corrected using a 1-bit ECC algorithm. The implementation of a 2-bit ECC algorithm, however, while providing increased error correction capabilities, is more expensive than a 1-bit ECC algorithm in terms of a number of calculations and power requirements.

Typically, when an ECC algorithm such as a 1-bit ECC algorithm is used to encode data contained within a page, either the entire page is encoded together, or only a data section of the page is encoded while an overhead section of the page remains unencoded. When an entire page is encoded together using a 1-bit ECC algorithm, then up to two incorrect bits may be detected and at most one of the incorrect bits may be corrected. Alternatively, when only the data section of the page is encoded using a 1-bit ECC algorithm, then up to two incorrect bits may be detected in the data section and at most one of the incorrect bits may be corrected in the data section, while no incorrect bits in the overhead area may be detected or corrected. In general, increasing the number of incorrect bits which may be detected and corrected in a page, *i.e.*, increasing error recovery capabilities, would enable the integrity of the data contained within the page to be increased. As a result, the overall reliability of a memory system which includes the page may be increased.

In one embodiment of the present invention, a page may be divided or otherwise grouped into separate segments. By dividing a page into segments, ECC calculations may be applied to encode data included in the segments such that each segment may be encoded substantially separately. Extending ECC calculations to enable segments to be separately encoded enables the overall number of detected and corrected incorrect bits in the page which includes the segments to be increased without incurring a significant amount of extra overhead. If a page is divided into at least two segments which each contain some data associated with the page, the two segments may be encoded separately using an ECC algorithm such as a 1-bit ECC algorithm. When the same ECC algorithm is used to encode each segment, *e.g.*, an ECC algorithm that detects up to two incorrect bits and corrects one incorrect bit, up to two incorrect bits in each segment may be detected, while one incorrect bit in each segment may be corrected. For example, when two segments are encoded using ECC algorithm which corrects up to one incorrect bit in each segment, then such an ECC algorithm may effectively enable up to two incorrect bits to be corrected in a page, as up to one incorrect bit in each of the two segments may be corrected. That is, additional incorrect bits may essentially be corrected substantially without requiring extra overhead or incurring a significant performance penalty. The ability to correct additional incorrect bits within a page allows the integrity of stored data to be improved and, hence, increases the reliability of an overall memory system.

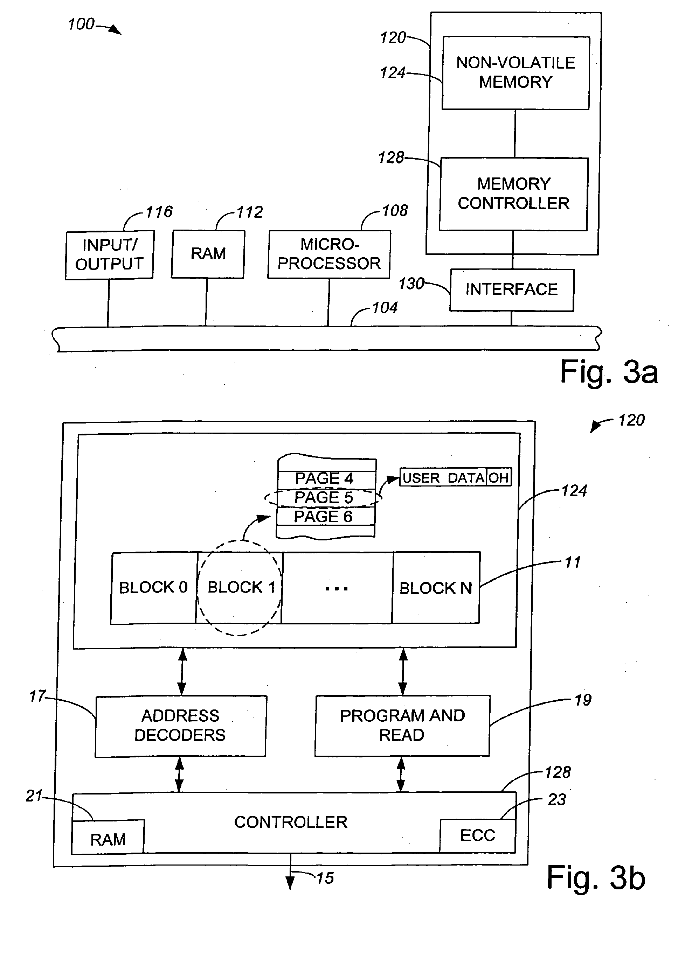

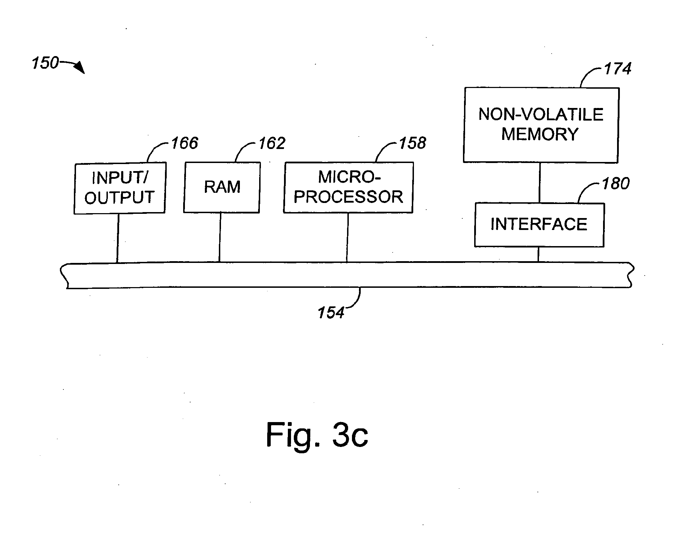

Flash memory systems or, more generally, non-volatile memory devices which may use a data integrity management implementation that allows a physical page within a system to be substantially divided into segments that are separately encoded using ECC algorithms generally include flash memory, *e.g.*, NAND or MLC NAND, cards and chip sets. Typically, flash memory systems are used in conjunction with a host system such that the host system may write data to or read data from the flash memory systems. However, some flash memory systems include embedded flash memory and software which executes on a host to substantially act as a controller for the embedded flash memory, as will be discussed below with respect to Fig. 3c. Referring to Fig. 3a, a general host system which includes a non-volatile memory device, *e.g.*, a CompactFlash memory card, will be described. A host or computer system 100 generally includes a system bus 104 which allows a microprocessor 108, a random access memory (RAM) 112, and input/output circuits 116 to communicate. It should be appreciated that host system 100 may generally include other components, *e.g.*, display devices and networking device, which are not shown for purposes of illustration.

In general, host system 100 may be capable of capturing information including, but not limited to, still image information, audio information, and video image information. Such information may be captured in real-time, and may be transmitted to host system 100 in a wireless manner. While host system 100 may be substantially any system, host system 100 is typically a system such as a digital camera, a video camera, a cellular communications device, an audio player, or a video player. It should be appreciated, however, that host system 100 may generally be substantially any system which stores data or information, and retrieves data or information.

Host system 100 may also be a system which either only captures data, or only retrieves data. That is, host system 100 may be, in one embodiment, a dedicated system which stores data, or host system 100 may be a dedicated system which reads data. By way of example, host system 100 may be a memory writer which is arranged only to write or store data. Alternatively, host system 100 may be a device such as an MP3 player which is typically arranged to read or retrieve data, and not to capture data.

A non-volatile memory device 120 which, in one embodiment, is a removable non-volatile memory device, is arranged to interface with bus 104 to store information. An optional interface block 130 may allow non-volatile memory device 120 to interface indirectly with bus 104. When present, input/output circuit block 116 serves to reduce loading on bus 104, as will be understood by those skilled in the art. Non-volatile memory device 120 includes non-volatile memory 124 and an optional memory control system 128. In one embodiment, non-volatile memory device 120 may be implemented on a single chip or a die. Alternatively, non-volatile memory device 120 may be implemented on a multi-chip module, or on multiple discrete components which may form a chip set and may be used together as non-volatile memory device 120. One embodiment of non-volatile memory device 120 will be described below in more detail with respect to Fig. 3b.

Non-volatile memory 124, *e.g.,* flash memory such as NAND flash memory or an MLC NAND flash memory, is arranged to store data such that data may be accessed and read as needed. Data stored in non-volatile memory 124 may also be erased as appropriate, although it should be understood that some data in non-volatile memory 124 may not be erasable. The processes of storing data, reading data, and erasing data are generally controlled by memory control system 128 or, when memory control system 128 is not present, by software executed by microprocessor 108. The operation of non-volatile memory 124 may be managed such that the lifetime of non-volatile memory 124 is substantially maximized by essentially causing sections of non-volatile memory 124 to be worn out substantially equally.

Non-volatile memory device 120 has generally been described as including an optional memory control system 128, *i.e.*, a controller. Often, non-volatile memory device 120 may include separate chips for non-volatile memory 124 and memory control system 128, i*.e.*, controller, functions. By way of example, while non-volatile memory devices including, but not limited to, PC cards, CompactFlash cards, MultiMedia cards, and secure digital cards include controllers which may be implemented on a separate chip, other non-volatile memory devices may not include controllers that are implemented on a separate chip. In an embodiment in which non-volatile memory device 120 does not include separate memory and controller chips, the memory and controller functions may be integrated into a single chip, as will be appreciated by those skilled in the art. Alternatively, the functionality of memory control system 128 may be provided by microprocessor 108, as for example in an embodiment in which non-volatile memory device 120 does not include memory controller 128, as discussed above.

With reference to Fig. 3b, non-volatile memory device 120 will be described in more detail in accordance with an embodiment of the present invention. As described above, non-volatile memory device 120 includes non-volatile memory 124 and may include memory control system 128. Memory 124 and control system 128, or controller, may be primary components of non-volatile memory device 120, although when memory 124 is an embedded NAND device such as an embedded MLC NAND memory, for example, non-volatile memory device 120 may not include control system 128. Memory 124 may be an array of memory cells formed on a semiconductor substrate, wherein one or more bits of data are stored in the individual memory cells by storing one of two or more levels of charge on individual storage elements of the memory cells. A non-volatile flash electrically erasable programmable read only memory (EEPROM) is an example of a common type of memory for such systems.

When present, control system 128 communicates over a bus 15 to a host computer or other system that is using the memory system to store data. Bus 15 is generally a part of bus 104 of Fig. 3a. Control system 128 also controls operation of memory 124, which may include a memory cell array 11, to write data provided by the host, read data requested by the host and perform various housekeeping functions in operating memory 124. Control system 128 generally includes a general purpose microprocessor which has associated non-volatile software memory, various logic circuits, and the like. One or more state machines are often also included for controlling the performance of specific routines.

Memory cell array 11 is typically addressed by control system 128 or microprocessor 108 through address decoders 17. Decoders 17 apply the correct voltages to gate and bit lines of array 11 in order to program data to, read data from, or erase a group of memory cells being addressed by the control system 128. Additional circuits 19 include programming drivers that control voltages applied to elements of the array that depend upon the data being programmed into an addressed group of cells. Circuits 19 also include sense amplifiers and other circuits necessary to read data from an addressed group of memory cells. Data to be programmed into array 11, or data recently read from array 11, are typically stored in a buffer memory 21 within control system 128. Control system 128 also usually contains various registers for temporarily storing command and status data, and the like.

Array 11 is divided into a large number of BLOCKS 0 - N memory cells. As is common for flash EEPROM systems, the block is typically the smallest unit of erase. That is, each block contains the minimum number of memory cells that are erased together. Each block is typically divided into a number of pages. As will be appreciated by those skilled in the art, a page may be the smallest unit of programming. That is, a basic programming operation writes data into or reads data from a minimum of one page of memory cells. One or more sectors of data are typically stored within each page. As shown in Fig. 3b, one sector includes user data and overhead data. Overhead data typically includes an ECC or other redundancy code that has been calculated from the user data of the sector. A portion 23 of the control system 128 calculates the ECC when data is being programmed into array 11, and also checks the ECC when data is being read from array 11. Alternatively, the ECCs are stored in different pages, or different blocks, than the user data to which they pertain.

A sector of user data is typically 512 bytes, corresponding to the size of a sector in magnetic disk drives. Overhead data, or redundant data, is typically an additional 16 bytes. One sector of data is most commonly included in each page but two or more sectors may instead form a page. Any number of pages may generally form a block. By way of example, a block may be formed from eight pages up to 512, 1024 or more pages. The number of blocks is chosen to provide a desired data storage capacity for the memory system. Array 11 is typically divided into a few sub-arrays (not shown), each of which contains a proportion of the blocks, which operate somewhat independently of each other in order to increase the degree of parallelism in the execution of various memory operations. An example of the use of multiple sub-arrays is described in U.S. Patent No. 5,890,192.

In one embodiment, non-volatile memory such as an MLC NAND memory is embedded into a system, *e.g.*, a host system. Fig. 3c is a diagrammatic representation of a host system which includes an embedded non-volatile memory. A host or computer system 150 generally includes a system bus 154 which allows a microprocessor 158, a RAM 162, and input/output circuits 166, among other components (not shown) of host system 150, to communicate. A non-volatile memory 174, *e.g.,* a flash memory, allows information to be stored within host system 150. An interface 180 may be provided between non-volatile memory 174 and bus 154 to enable information to be read from and written to non-volatile memory 174.

Non-volatile memory 174 may be managed by microprocessor 158 which effectively executes either or both software and firmware which is arranged to control non-volatile memory 174. That is, microprocessor 158 may run code devices (not shown), *i.e.*, software code devices or firmware code devices, which allow non-volatile memory 174 to be controlled. Such code devices, which may be a flash memory packaged with CPU inside microprocessor 158, a separate flash ROM, or inside non-volatile memory 174, which will be described below, may enable physical blocks in non-volatile memory 174 to be addressed, and may enable information to be stored into, read from, and erased from the physical blocks.

A page which is included in a non-volatile memory such as non-volatile 174 may be divided into segments of data which may be separately encoded using an ECC algorithm, as previously mentioned. The segments may be of the same size or different sizes. Typically, when an overhead or redundant area of a page is to be encoded, the overhead or redundant area of the page forms one segment, whereas the data area of the page may for either a single segment or a plurality of segments.

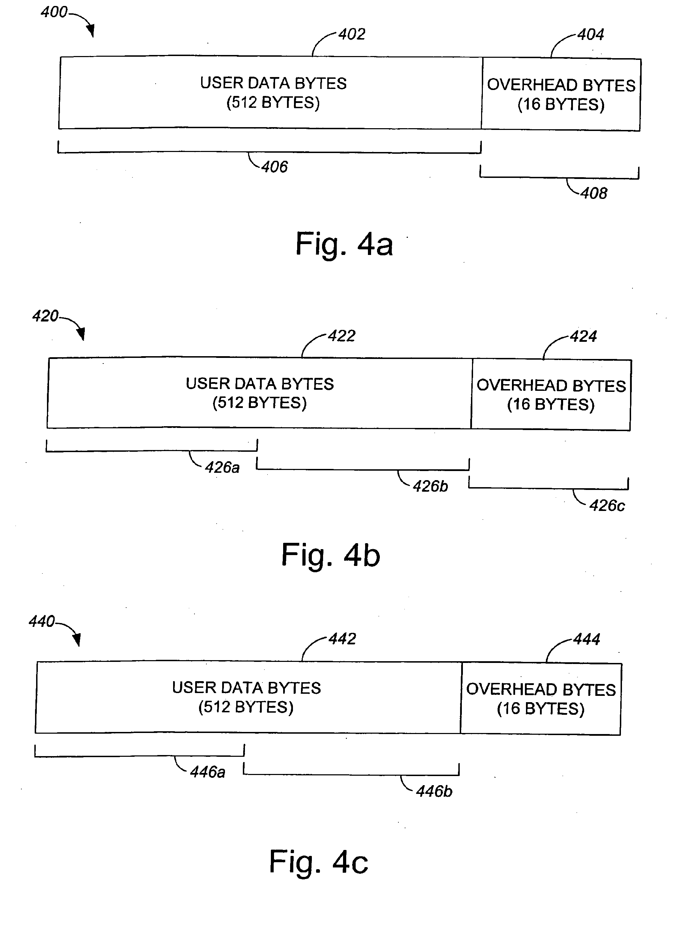

As shown in Fig. 4a, a data section 402 which contains user data and an overhead area 404, or a redundant area, may be encoded or otherwise processed substantially separately as a first segment 406 and a second segment 408. That is, a page 400 which includes data section 402 and overhead area 404 may be divided into segments 406, 408 which are encoded separately. Typically, both segments 406, 408 are encoded using substantially the same ECC algorithm, *e.g.*, a 1-bit ECC algorithm, although it should be appreciated that the algorithm used to encode segment 406 and the algorithm used to encode segment 408 may differ.

Since bad or incorrect bits may be substantially randomly distributed within page 400, using a 1-bit ECC algorithm to encode segment 406 and segment 408 separately may potentially allow for one incorrect bit to be corrected within segment 406, while two incorrect bits may be detected within segment 406, and one incorrect bit to be corrected within segment 408, while two incorrect bits may be detected within segment 408. Hence, by implementing a 1-bit ECC algorithm on page 400 two times, up to two incorrect bits may effectively be corrected without incurring significant overhead associated with implementing a 2-bit ECC algorithm.

In one embodiment, a 2-bit ECC algorithm may be used to separately encode segment 406 and segment 408, thereby enabling up to two incorrect bits to be corrected within segment 406 and up to two incorrect bits to be corrected within segment 408. Although the overhead associated with implementing a 2-bit ECC algorithm is significantly higher than the overhead associated with implementing a 1-bit ECC algorithm, in order to further ensure the integrity of bytes contained in either data section 402 or overhead area 404, a 2-bit ECC algorithm may be chosen for use.

Generally, the number of segments which are included in a page may be determined by the number of incorrect bits which a system wishes to detect and to correct. Typically, as the number of incorrect bits which are to be corrected increases, the number of segments may increased. In addition, the number of segments may also be dependent upon the number of parity bits which the system is capable of storing, as for example in an overhead area of a page. By way of example, a page may be divided into approximately three segments, although the number of segments may generally be substantially any number that is greater than or equal to two.

Fig. 4b is a diagrammatic representation of a page which is effectively divided into three segments which may be separately encoded using an ECC algorithm in accordance with an embodiment of the present invention. A page 420, which includes a data section 422 and an overhead area 424 may be divided into three segments 426, 428. Typically, overhead area 424 is a single segment 428, while user area may be divided into segments 426a, 426b, which may be of approximately the same size, *e.g.*, approximately 256 bytes each when overhead area 424 is arranged to include 512 bytes.

Each segment 426, 428 is encoded separately using an ECC algorithm. When the ECC algorithm used to encode segments 426, 428 is a 1-bit ECC algorithm, then up to two incorrect bits in each segment 426, 428 may be detected, and one incorrect bit in each segment may be corrected. Hence, up to six incorrect bits within page 420 may be detected, while up to three incorrect bits may be corrected when a 1-bit ECC algorithm is implemented. Alternatively, it should be appreciated that the ECC algorithm used to encode segments 426, 428 allow approximately two bits in each segment 426, 428 to be corrected, while up to three incorrect bits may be corrected in each segment 426, 428.

When each segment 426, 428 is encoded using a 1-bit ECC algorithm or extended 1-bit ECC calculations, then up to three bits within page 420 may effectively be corrected using a 1-bit algorithm. Three bits may typically be corrected when incorrect bits are spread out between segment 426a, segment 426b, and segment 428. Hence, the integrity of user data stored in data section 422 and the integrity of overhead data stored in overhead area 424 may effectively be improved without incurring substantial additional overhead, since more errors within page 420 may be detected and corrected.

Although an overhead area of a page is typically encoded using an ECC algorithm, it may be possible for the overhead area to remain unencoded or to be encoded using some other algorithm in some instances. As shown in Fig. 4c, a data section 442 of a page 440 may be encoded as separate segments 446 using an ECC algorithm such as a 1-bit ECC algorithm, while an overhead area 444 may not be encoded using an ECC algorithm, *e.g.*, may be encoded using a different algorithm. Separate segments 446 are generally of approximately the same size, *i.e.*, segment 446a and segment 446b typically each include the same number of bytes.

Data section 442 may generally be encoded as two separate segments 446a, 446b, although the number of segments into which data section 442 may be divided may vary. By way of example, instead of being divided into two segments 446a, 446b, data section 442 may instead be divided into three segments. When ECC calculations are extended to enable three separate segments to be encoded, the number of parity bits which are associated with an ECC algorithm and, hence, are stored in overhead area 444, is typically approximately eight. The overhead parity bits are also stored in the overhead area. While data section 442 may generally be divided into more than three segments, the number of parity bits which are typically needed to correct data fields when data section 442 is divided into more than three segments may be too high to be readily stored into overhead area 444.

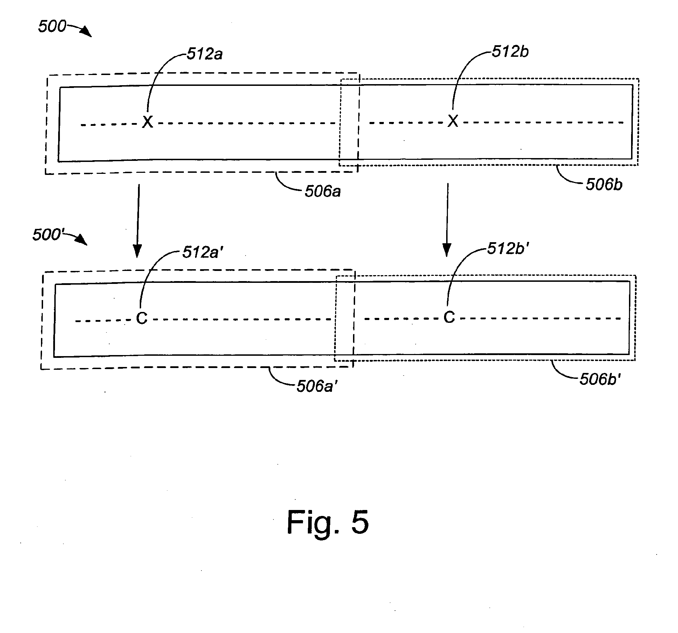

As discussed above, by breaking a page into separate segments which may be encoded by extending ECC calculations or ECC algorithms, the number of bits which may be corrected using an ECC algorithm may be increased. That is, a 1-bit ECC algorithm which generally enables one bit to be corrected may be extended to enable one bit in each segment of a page to be corrected. Referring next to Fig. 5, a process of correcting more than one bit associated with a page using a 1-bit ECC algorithm will be described in accordance with an embodiment of the present invention. A page 500 may include two segments 506. It should be appreciated that both segment 506a and segment 506b may both be associated with a data section or area of page 500, or segment 506a may encompass a data section of page 500 while segment 506b encompasses an overhead area of page 500.

In the described embodiment, a 1-bit ECC algorithm is extended to encode segments 506. As such, one bit in each segment 506 may be corrected using a 1-bit ECC algorithm. Bits within segment 506a include an incorrect bit 512a, while bits within segment 506b include an incorrect bit 512b. Incorrect bit 512a may be corrected to become bit 512a' within segment 506a', while incorrect bit 512b may be corrected to become bit 512b' within segment 506b', during an error recovery process which is associated with a 1-bit ECC algorithm.

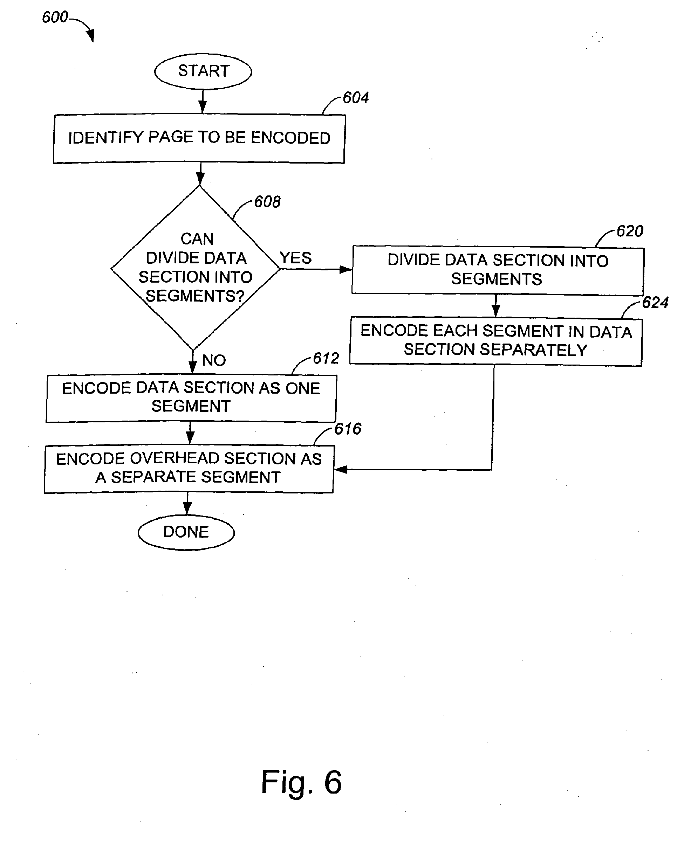

With reference to Fig. 6, one method of encoding data associated with a page by dividing or otherwise breaking the page into segments and implementing an extended ECC algorithm will be described in accordance with an embodiment of the present invention. A process 600 of encoding data begins at step 604 in which a page that is to be encoded using an ECC algorithm is identified. Once the page is identified, a determination is made in step 608 regarding whether the data section of the page is to be divided into segments. If it is determined that the data section of the page is to be divided into segments, then the data section is divided into segments in step 620. The number of segments associated with the data section may generally be varied. By way of example, the data section may include two segments or three segments.

After the data section is divided into segments, each segment in the data section may be encoded substantially separately in step 624. That is, ECC calculations, as for example ECC calculations associated with a 1-bit ECC algorithm, may be extended such that each segment created in step 620 may be encoded substantially separately. Upon encoding each segment in the data section, then the overhead section is encoded as a separate segment in step 616, *e.g.*, using substantially the same ECC algorithm used to encode the segments associated with the data section in step 624, and the process of encoding data is completed.

Returning to step 608, if it is determined that the data section is not to be divided into segments, then the indication is that the data section is to be encoded as a substantially single segment. Accordingly, process flow moves from step 608 to step 612 in which the data section is encoded as a single segment. As discussed above, the data section may be encoded using an ECC algorithm such as a 1-bit ECC algorithm. Once the data section is encoded, the overhead section or area is encoded as a substantially separate segment in step 616, and the process of encoding data is completed.

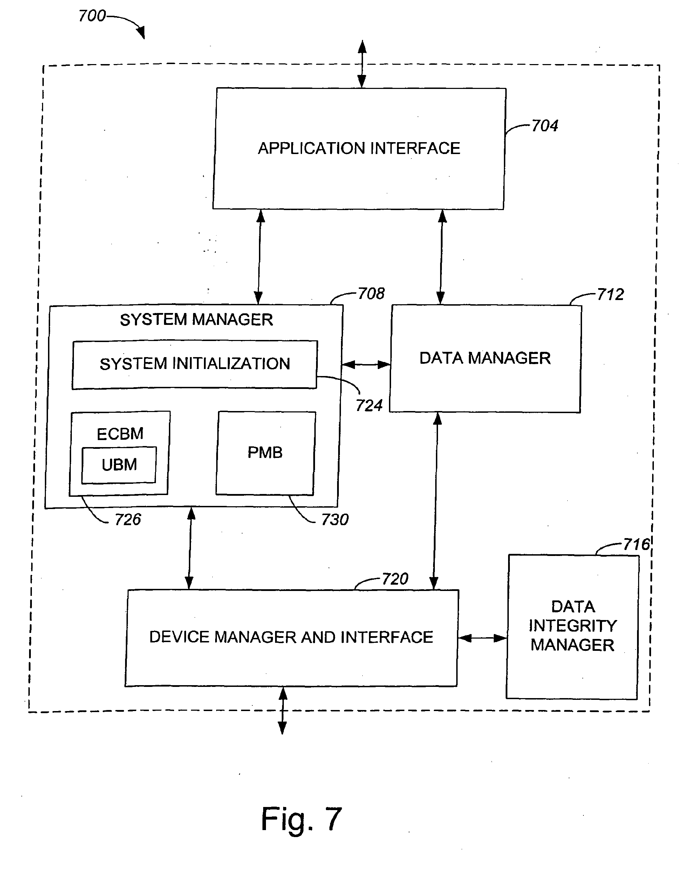

The functionality associated with implementing a system which allows segments associated with a page to be separately encoded using an ECC algorithm is generally provided in software, *e.g.*, as program code devices, or as firmware to a host system which includes a non-volatile memory or non-volatile memory component. One embodiment of a suitable system architecture associated with the software or firmware provided to a host system is shown in Fig. 7. A system architecture 700 generally includes a variety of modules which may include, but are not limited to, an application interface module 704, a system manager module 708, a data manager module 712, a data integrity manager 716, and a device manager and interface module 720. In general, system architecture 700 may be implemented using software code devices or firmware which may be accessed by a processor, *e.g.*, processor 108 of Fig. 3a.

In general, application interface module 704 may be arranged to communicate with the host, operating system or the user directly. Application interface module 704 is also in communication with system manager module 708 and data manager module 712. When the user wants to read, write or format a flash memory, the user sends requests to the operating system, the requests are passed to the application interface module 704. Application interface module 704 directs the requests to system manager module 708 or data manager module 712 depending on the requests.

System manager module 708 includes a system initialization submodule 724, an erase count block management submodule 726, and a power management block submodule 730. System initialization submodule 724 is generally arranged to enable an initialization request to be processed, and typically communicates with erase count block management submodule 726. System initialization module 724 is also arranged to resolve a one-to-many logical-to-physical block assignment.

Erase count block management submodule 726 includes functionality to cause erase counts of blocks to be stored, and functionality to cause an average erase count to be calculated, as well as updated, using individual erase counts. In other words, erase count block management submodule 726 effectively allows erase counts to be cataloged and allows an average erase count to be maintained. Further, in one embodiment, erase count block management submodule 726 also substantially synchronizes the erase count of substantially all blocks in an erase count block during a initialization request of an overall system. While erase count block management submodule 726 may be arranged to cause an average erase count to be stored in an erase count block, it should be appreciated that power management block submodule 730 may instead be used to enable the average erase count to be stored.

In addition to being in communication with application interface module 704, system manager module 708 is also in communication with data manager module 712, as well as device manager and interface module 720. Data manager module 712, which communicates with both system manager module 708 and application interface module 704, may include functionality to provide sector mapping which effectively translates logical sectors into physical sectors. That is, data manager module 712 is arranged to map logical blocks into physical blocks. Data manager module 712 may also include functionality associated with operating system and file system interface layers, and enables groups within blocks to be managed, as described in co-pending U.S. Patent Application No. 10/281,855, filed October 28, 2002. In one embodiment, data manager module 712 may be arranged to enable a substantially out-of-sequence write process to occur.

Device manager and interface module 720, which is in communication with system manager module 708, data manager 712, and data integrity manager 716, typically provides a flash memory interface, and includes functionality associated with hardware abstractions, *e.g.*, an I/O interface. Data integrity manager module 716 provides ECC handling, among other functions.

Although only a few embodiments of the present invention have been described, it should be understood that the present invention may be embodied in many other specific forms without departing from the spirit or the scope of the present invention. By way of example, a 1-bit ECC algorithm has been described as being suitable for use to encode contents of segments of a page substantially separately. It should be appreciated, however, that in some embodiments, other types of ECC algorithms such as a 2-bit ECC algorithm may be used to encode contents of the segments of a page substantially separately. Embodiments for which a 2-bit ECC algorithm may be suitable include embodiments in which a page is divided into two segments, and embodiments in which there may be ample storage space to hold parity bits associated with a 2-bit ECC algorithm.

Additionally, while ECC algorithms have generally been described as being 1-bit ECC algorithms or 2-bit ECC algorithms, the ECC algorithms may instead by 1-symbol ECC algorithms or 2-symbol ECC algorithms, respectively. Further, the actual ECC algorithms used may vary widely. Suitable ECC algorithms may include, but are not limited to, Reed-Solomon algorithms, Hamming code algorithms, and binary Hamming Code algorithms. For instance, in one embodiment, a suitable 1-bit ECC algorithm which enables segments of a page to be encoded substantially separately may be a Hamming code algorithm, while a suitable 2-bit ECC algorithm may be a Reed-Solomon algorithm.

While substantially the same ECC algorithm may be applied to different segments of a page, it should be appreciated that different ECC algorithms may instead be applied to different segments of the page. In other words, while the same type of encoding is generally performed for encoded sections of a page, different types of encoding may instead be used.

Typically, when a data section of a page is divided into segments, the segments are of substantially equal size, *i.e.,* the segments each include approximately the same number of bits. It should be appreciated, however, that the size of the segments may also vary in some instances.

The steps associated with the various methods of the present invention may be widely varied. In general, steps may be added, removed, reordered, and altered without departing from the spirit or the scope of the present invention. Therefore, the present examples are to be considered as illustrative and not restrictive, and the invention is not to be limited to the details given herein, but may be modified within the scope of the appended claims.

Each feature disclosed in this specification (which term includes the claims) and/or shown in the drawings may be incorporated in the invention independently of other disclosed and/or illustrated features.

The text of the abstract filed herewith is repeated here as part of the specification.

Methods and apparatus for encoding data associated with a page by dividing the page into segments and separately encoding the segments using extended error correction code (ECC) calculations are disclosed. According to one aspect of the present invention, a method for encoding data associated with a page which has a data area and an overhead area within a non-volatile memory of a memory system includes dividing at least a part of the page into at least two segments of the data, the at least two segments of the data including a first segment and a second segment, and performing ECC calculations on the first segment to encode the first segment. The method also includes performing the ECC calculations on the second segment to encode the second segment substantially separately from the first segment.

### CROSS REFERENCE TO RELATED APPLICATIONS

The present invention is related to co-pending U.S. Patent Application Nos. 10/281,739, 10/281,823, 10/281,670, 10/281,824, 10/281,631, 10/281,855, 10/281,762, 10/281,696, 10/281,626, and 10/281,804, as well as co-pending U.S. Provisional Patent Application Nos. 60/421,910, 60/421,725, 60/421,965, 60/422,166, 60/421,911, and 60/421,746, each filed on October 28, 2002, which are each incorporated herein by reference in their entireties.

## Claims

1. A method for encoding data associated with a page within a non-volatile memory of a memory system, the page having a data area and an overhead area, the method comprising:
dividing at least a part of the page into at least two segments of the data, the at least two segments of the data including a first segment and a second segment;
performing error correction code (ECC) calculations on the first segment to encode the first segment; and
performing the ECC calculations on the second segment to encode the second segment, wherein the second segment is encoded substantially separately from the first segment.

2. The method of claim 1 wherein the first segment includes the data area and the second segment includes the overhead area.

3. The method of claim 1 wherein the first segment includes a first section of the data area and the second segment includes a second section of the data area.

4. The method of any preceding claim wherein the ECC calculations are associated with an ECC algorithm that is arranged to detect up to two incorrect bits and to correct up to one of the incorrect bits in each of the first segment and the second segment.

5. The method of claim 4 wherein the ECC algorithm is a Hamming Code ECC algorithm.

6. The method of claim 1, 4 or 5 wherein dividing the at least part of the page into the at least two segments of the data includes:
dividing the page into three segments, the three segments including the first segment, the second segment, and a third segment.

7. The method of claim 6 further including:
performing the ECC calculations on the third segment to encode the third segment, wherein the third segment is encoded substantially separately from the first segment and the second segment.

8. The method of claim 6 or 7 wherein the first segment includes a first section of the data area, the second segment includes a second section of the data area, and the third segment includes the overhead area.

9. The method of claim 6 or 7 wherein the first segment includes a first section of the data area, the second segment includes a second section of the data area, and the third segment includes a third section of the data area.

10. The method of any preceding claim wherein the non-volatile memory is one of a NAND flash memory and an MLC NAND flash memory.

11. A memory system comprising:
a non-volatile memory, the non-volatile memory including a page, the page having a data area and an overhead area, the data area and the overhead area being arranged to contain bits of data;
means that divide at least a part of the page into at least two segments, the at least two segments including a first segment and a second segment; and
means that perform error correction code (ECC) calculations on the first segment to encode the first segment and on the second segment to encode the second segment, wherein the second segment is encoded substantially separately from the first segment.

12. The memory system of claim 11 comprising a memory area for storing the dividing means and the EEC calculation performing means.

13. The memory system of claim 11 or 12 further including:
a controller, the controller being arranged to process the dividing means and the EEC calculation performing means.

14. The memory system of claim 11, 12 or 13 wherein the first segment includes the data area and the second segment includes the overhead area.

15. The memory system of claim 11, 12 or 13 wherein the first segment includes a first section of the data area and the second segment includes a second section of the data area.

16. The memory system of any of claims 11 to 15 wherein the ECC calculations are associated with an ECC algorithm that is arranged to detect up to two incorrect bits and to correct up to one of the incorrect bits in each of the first segment and the second segment.

17. The memory system of claim 16 wherein the ECC algorithm is a Hamming Code ECC algorithm.

18. The memory system of claim 11, 16 or 17 wherein the means that divide the at least part of the page into the at least two segments include:
means that divide the page into three segments, the three segments including the first segment, the second segment, and a third segment.

19. The memory system of claim 18 further including:
means that perform the ECC calculations on the third segment to encode the third segment, wherein the third segment is encoded substantially separately from the first segment and the second segment.

20. The memory system of claim 18 wherein the first segment includes a first section of the data area, the second segment includes a second section of the data area, and the third segment includes the overhead area.

21. The memory system of claim 18 wherein the first segment includes a first section of the data area, the second segment includes a second section of the data area, and the third segment includes a third section of the data area.

22. The memory system of any of claims 11 to 21 wherein the non-volatile memory is one of a NAND flash memory and an MLC NAND flash memory.

23. The memory system of any of claims 11 to 22 wherein the dividing means and the EEC calculation performing means are code devices being one of software code devices and firmware code devices.
